# EUROPÄISCHE PATENTSCHRIFT

(11) **EP 3 610 706 B1**
(45) Veröffentlichungstag und Bekanntmachung des Hinweises auf die Patenterteilung: **09.08.2023**
(21) Anmeldenummer: 18713847.4
(22) Anmeldetag: 21.03.2018
(51) Int. Cl.: H05K 3/30, H05K 3/34, H05K 1/18, H05K 1/14

(54) **VERFAHREN ZUM HERSTELLEN EINES ELEKTRONISCHEN SENSORMODULS**
METHOD FOR PRODUCING AN ELECTRONIC SENSOR MODULE
PROCÉDÉ DE FABRICATION D'UN MODULE DE CAPTEUR ÉLECTRONIQUE

(30) Priorität: 10.04.2017 DE 102017206105
(43) Veröffentlichungstag der Anmeldung: 19.02.2020
(73) Patentinhaber: Robert Bosch GmbH, 70442 Stuttgart (DE)
(72) Erfinder: KAESS, Udo, 74399 Walheim (DE); KATZENWADEL, Uwe, 71739 Oberriexingen (DE); WEIBERLE, Peter, 74343 Sachsenheim (DE)
(86) Internationale Anmeldenummer: PCT/EP2018/057135
(87) Internationale Veröffentlichungsnummer: WO 2018/188924

(56) Entgegenhaltungen:
- DE-A1-102013 100 197
- DE-A1-102014 216 587
- DE-A1-102014 217 556
- US-A1- 2005 161 492
- US-A1- 2015 334 843

## Beschreibung

### Gebiet der Erfindung

Die Erfindung betrifft ein Verfahren zum Herstellen eines elektronischen Sensormoduls zum Messen mindestens einen Messwerts, insbesondere für eine Getriebesteuerung.

### Stand der Technik

In Getriebesteuerungen muss typischerweise mindestens ein erster Messwert erfasst bzw. gemessen werden. Die Getriebesteuerung umfasst oftmals ein elektronisches Sensormodul mit einem Leiterplattenelement, auf dem die elektronischen Bauelemente angeordnet sind. Ein Sensorelement bzw. Sensor ist mittels eines Sensorträgers bzw. Sensordoms in einem Abstand zu dem Leiterplattenelement angeordnet und mit dem Leiterplattenelement elektrisch verbunden. Die Höhe des Sensordoms kann derart ausgewählt werden, dass das Sensorelement bzw. der Sensor in einem festgelegten Abstand zu einem messenden Objekt bzw. zu dem Leiterplattenelement angeordnet ist.

Der Sensorträger bzw. der Sensordom wird auf dem Leiterplattenelement mechanisch befestigt und mit dem Leiterplattenelement elektrisch verbunden. Das Sensorelement bzw. der Sensor wird ebenfalls mechanisch und elektrisch mit dem Sensordom bzw. Sensorträger verbunden.

Nachteilig an bisher bekannten Verfahren zum Herstellen eines elektronischen Sensormoduls ist, dass diese sehr aufwendig sind und eine lange Zeit benötigen.

Aus der US 2005/161492 A1 ist ein Verfahren zum Herstellen eines elektronischen Moduls bekannt, welches die folgenden Schritte umfasst:
Bereitstellen eines Leiterplattenelements; Bereitstellen eines Bauelements;
Bereitstellen eines Trägers, auf welchem das Bauelement angeordnet werden kann, wobei der Träger elektrische Verbindungsleitungen zwischen Löt-Pads, die auf einer von der Leiterplattenkontaktseite abgewandten Seite des Trägers angeordnet sind, und elektrischen Löt-Pads einer Leiterplattenelementkontaktseite des Trägers aufweist, Aufbringen von erstem Lötmaterial auf elektrische Löt-Pads des Leiterplattenelements und/oder auf die elektrischen Löt-Pads der Leiterplattenelementkontaktseite des Trägers;
Anordnen des Trägers mit den elektrischen Löt-Pads der Leiterplattenelementkontaktseite auf den elektrischen Löt-Pads des Leiterplattenelements zum Herstellen jeweils einer elektrischen Verbindung zwischen der Verbindungsleitung und dem Leiterplattenelement über das erste Lötmaterial;
Aufbringen von zweitem Lötmaterial auf elektrische Verbindungselemente des Bauelements und/oder auf die Löt-Pads auf einer von der Leiterplattenkontaktseite abgewandten Seite des Trägers;
Anordnen des Bauelements auf dem Träger derart, dass das zweite Lötmaterial jeweils eine elektrische Verbindung zwischen den elektrischen Verbindungselementen des Bauelements und den Löt-Pads auf der von der Leiterplattenkontaktseite abgewandten Seite des Trägers über das zweite Lötmaterial herstellt; und
Reflow-Löten des ersten Lötmaterials und des zweiten Lötmaterials in einem gemeinsamen Reflow-Lötvorgang.

Aus US 2015/334843 A1 ist eine Leiterplatte und ein Verfahren zur Herstellung einer Leiterplatte bekannt, wobei die Leiterplatte ein erstes Element und ein zweites Element sowie ein erstes Grundsubstrat, in welches das erste Element eingebettet ist, und einen Hohlraum aufweist, in den das zweite Element eingebracht ist. Eine zweites Grundsubstrat ist auf dem ersten Grundsubstrat befestigt.

Aus der DE 10 2014 217556 A1 ist eine Sensordomvorrichtung für ein Kraftfahrzeug bekannt, welche einen lang gestreckten Sensordomkörper mit einer elektrischen Zuleitung aufweist, welche innerhalb des Sensordomkörpers verläuft. Die Sensordomvorrichtung weist eine Leiterplatte, welche an einem Ende des Sensordomkörpers angeordnet ist, und ein Sensorelement auf, welches auf der Leiterplatte angeordnet und mit der elektrischen Zuleitung elektrisch gekoppelt ist zum elektrischen Koppeln des Sensorelements mit einer elektrischen Komponente außerhalb der Sensordomvorrichtung.

Aus der DE 10 2014 216587 A1 ist ein Sensormodul bekannt, das einen gehäusten Sensor mit Anschlusspins aufweist, und mindestens ein elektrisches Bauteil, das mit dem Sensor elektrisch leitend verbunden ist, und eine mehrlagige Leiterplatte. Der Sensor und das Bauteil sind in die Leiterplatte eingebettet.

Aus der DE 10 2013 100197 A1 ist eine Sensoreinheit für ein Kraftfahrzeug bekannt, bei welcher die Sensoreinheit einen räumlichen, spritzgegossenen Kunststoffträger aufweist, welcher mit einer Seite auf einer Leiterplatte angeordnet werden kann. Der Kunststoffträger weist zumindest einen elektrischen Kontakt von der Sensoreinheit zur Leiterplatte hin auf. Die elektrischen Kontakte des Kunststoffträgers zur Leiterplatte hin sind als SMDlötfähige Flächenkontakte ausgebildet und werden mit den anderen SMD-Bauelementen in einem gemeinsamen Reflowlötprozess verlötet.

### Offenbarung der Erfindung

### Vorteile der Erfindung

Ausführungsformen der vorliegenden Erfindung können in vorteilhafter Weise ermöglichen, technisch einfach ein Sensormodul in kurzer Zeit herzustellen.

Gemäß einem ersten Aspekt der Erfindung wird ein Verfahren zum Herstellen eines elektronischen Sensormoduls zum Messen mindestens einen Messwerts, insbesondere für eine Getriebesteuerung, vorgeschlagen, wobei das Verfahren folgende Schritte umfasst: Bereitstellen eines Leiterplattenelements; Bereitstellen eines Sensorelements; Bereitstellen eines Sensorträgers mit einer Sensoraufnahme zum Aufnehmen des Sensorelements, wobei die Sensoraufnahme Ausrichtungselemente zum Ausrichten des Sensorelements in der Sensoraufnahme aufweist, wobei der Sensorträger elektrische Verbindungsleitungen zwischen Löt-Pads der Sensoraufnahme und elektrischen Löt-Pads einer Leiterplattenelementkontaktseite des Sensorträgers aufweist, wobei die Sensoraufnahme auf einer der Leiterplattenelementkontaktseite abgewandten Seite des Sensorträgers ausgebildet ist; Aufbringen von erstem Lötmaterial auf elektrische Löt-Pads des Leiterplattenelements und/oder auf die elektrischen Löt-Pads der Leiterplattenelementkontaktseite des Sensorträgers; Anordnen des Sensorträgers mit den elektrischen Löt-Pads der Leiterplattenelementkontaktseite auf den elektrischen Löt-Pads des Leiterplattenelements zum Herstellen jeweils einer elektrischen Verbindung zwischen der Verbindungsleitung und dem Leiterplattenelement über das erste Lötmaterial; Aufbringen von zweitem Lötmaterial auf elektrische Verbindungselemente des Sensorelements und/oder auf die Löt-Pads der Sensoraufnahme; Anordnen des Sensorelements in der Sensoraufnahme derart, dass das zweite Lötmaterial jeweils eine elektrische Verbindung zwischen den elektrischen Verbindungselementen des Sensorelements und den Löt-Pads der Sensoraufnahme über das zweite Lötmaterial herstellt; und Reflow-Löten des ersten Lötmaterials und des zweiten Lötmaterials in einem gemeinsamen Reflow-Lötvorgang. Durch die Ausrichtungselemente wird das Einsetzen des Sensorelements in die Sensoraufnahme vereinfacht und kann besonders präzise durchgeführt werden. Somit wird die Zeit für die Herstellung in der Regel noch weiter verringert.

Von dem aus der eingangs zitierten US 2005/161492 A1 unterscheidet sich das Verfahren nicht nur dadurch, dass das Modul als Sensormodul, der Träger als Sensorträger und das Bauelement als Sensorelement ausgebildet ist, sondern insbesondere dadurch, dass der Sensorträger mit einer Sensoraufnahme zum Aufnehmen des Sensorelements ausgebildet ist, wobei die Sensoraufnahme Ausrichtungselemente zum Ausrichten des Sensorelements in der Sensoraufnahme aufweist,

Ein Vorteil hiervon ist, dass in der Regel Zeit und Energie gespart wird, da das Sensorelement mit dem Sensorträger sowie der Sensorträger mit dem Leiterplattenelement in einem einzigen Reflow-Lötvorgang verbunden werden. Hierdurch werden üblicherweise die Herstellungskosten gesenkt. Zudem ist im Allgemeinen sichergestellt, dass die Verbindung zwischen dem Sensorelement und dem Sensorträger sowie zwischen dem Sensorträger und dem Leiterplattenelement den gleichen Temperarturen ausgesetzt wird. Dies führt typischerweise zu besonders gleichmäßigen Reflow-Lötverbindungen.

Gemäß einer Ausführungsform umfasst das Verfahren ferner folgende Schritte:

Bereitstellen von weiteren elektronischen Bauelementen, insbesondere von weiteren elektronischen Bauelementen, vorzugsweise weiteren passiven elektronischen Bauelementen, zum Herstellen einer elektromagnetischen Verträglichkeit des Sensormoduls; Aufbringen eines dritten Lötmaterials auf elektrische Verbindungselemente der weiteren elektronischen Bauelemente und/oder auf weitere Löt-Pads des Leiterplattenelements; und Anordnen der weiteren elektronischen Bauelemente jeweils auf den weiteren Löt-Pads des Leiterplattenelements zum Herstellen jeweils einer elektrischen Verbindung zwischen den weiteren elektronischen Bauelementen und dem Leiterplattenelement über das dritte Lötmaterial; wobei das dritte Lötmaterial in demselben Reflow-Lötvorgang reflow-gelötet wird, in dem das erste Lötmaterial und das zweite Lötmaterial gemeinsam reflow-gelötet wird. Ein Vorteil hiervon ist, dass in der Regel die für die Herstellung benötigte Zeit weiter verringert wird. Zudem werden die drei Lötmaterialien typischerweise besonders gleichmäßig reflow-gelötet.

Gemäß einer Ausführungsform umfasst das Leiterplattenelement ferner mechanische Löt-Pads und die Leiterplattenelementkontaktseite des Sensorträgers umfasst ferner mechanische Löt-Pads, wobei auf die mechanischen Löt-Pads des Leiterplattenelements und/oder der Leiterplattenelementkontaktseite des Sensorträgers ebenfalls erstes Lötmaterial aufgetragen wird, wobei bei dem Anordnen des Sensorträgers mit der Leiterplattenelementkontaktseite auf dem Leiterplattenelement zudem die mechanischen Löt-Pads der Leiterplattenelementkontaktseite des Sensorträgers über das erste Lötmaterial mit den mechanischen Löt-Pads des Leiterplattenelements verbunden werden, wobei das erste Lötmaterial der mechanischen Löt-Pads in demselben Reflow-Lötvorgang wie das erste Lötmaterial der elektrischen Löt-Pads reflow-gelötet wird. Vorteilhaft hieran ist, dass durch den denselben Reflow-Lötvorgang einerseits das Sensorelement über den Sensorträger mit dem Leiterplattenelement elektrisch verbunden und andererseits zugleich der Sensorträger mechanisch an dem Leiterplattenelement befestigt wird. Dies senkt in der Regel die Zeit für die Herstellung des Sensormoduls noch weiter.

Gemäß einer Ausführungsform ist der Sensorträger ausschließlich über das erste Lötmaterial mechanisch mit dem Leiterplattenelement verbunden. Ein Vorteil hiervon ist, dass der Sensorträger typischerweise technisch besonders einfach sowohl elektrisch als auch mechanisch mit dem Leiterplattenelement verbunden wird. Zudem wird in der Regel Löt-Material eingespart, so dass die Herstellungskosten weiter sinken.

Gemäß einer Ausführungsform ist das Sensorelement ausschließlich über das zweite Lötmaterial mechanisch mit dem Sensorträger verbunden. Vorteilhaft hieran ist, dass das Sensorelement in der Regel technisch besonders einfach sowohl elektrisch als auch mechanisch mit dem Sensorträger verbunden wird.

Gemäß einer Ausführungsform umfasst das Verfahren ferner folgenden Schritt: Aufbringen eines Vergussmaterials auf zumindest einen Teil des Leiterplattenelements derart, dass die elektrische Verbindung oder die elektrischen Verbindungen zwischen dem Sensorträger und dem Leiterplattenelement von dem Vergussmaterial bedeckt sind, und in zumindest einen Teil der Sensoraufnahme derart, dass die elektrischen Verbindungen zwischen dem Sensorelement und dem Sensorträger bedeckt sind. Ein Vorteil hiervon ist, dass die elektrischen Kontaktstellen bzw. Kontaktbereiche in der Regel technisch besonders einfach gegenüber der Umgebung geschützt sind. Dies ist insbesondere vorteilhaft, wenn das Sensormodul in einer Ölumgebung angeordnet bzw. betrieben wird. In dem Öl können unter ungünstigen Umständen Metallpartikel vorhanden sein, die einen Kurzschluss auslösen können. Somit wird in der Regel durch das Bedecken mit Vergussmaterial ein besonders kurzschlusssicheres Steuermodul erreicht.

Gemäß einer Ausführungsform wird das Vergussmaterial derart in die Sensoraufnahme eingebracht, dass ein von dem Sensorträger abgewandte Seite des Sensorelements nicht von dem Vergussmaterial bedeckt ist. Hierdurch ist es in der Regel möglich, einen Luftspalt zwischen dem Sensorelement bzw. dem Sensor 90 und dem Element (z.B. ein Rad eines Fahrzeugs oder einem Gebermagneten), dessen Eigenschaft bzw.

Eigenschaften mittels des Sensors bzw. Sensorelements erfasst werden, sehr gering bzw. klein zu halten. Dies verbessert typischerweise die Präzision, mit der der Messwert bzw. die Messwerte von dem Sensormodul erfasst werden.

Gemäß einer Ausführungsform umfasst das Sensorelement einen Hall-Sensor, wobei die Sensoraufnahme eine Vertiefung zum Aufnehmen eines Dauermagneten derart aufweist, dass der Dauermagnet zwischen dem Sensorelement und dem Leiterplattenelement anordenbar ist, wobei vor dem Einbringen des Sensorelements in die Sensoraufnahme, der Dauermagnet in die Vertiefung eingebracht wird. Hierdurch kann typischerweise technisch einfach in kurzer Zeit ein Sensormodul hergestellt werden, mittels dem ein Magnetfeld bzw. eine Drehzahl gemessen werden kann.

Es wird darauf hingewiesen, dass einige der möglichen Merkmale und Vorteile der Erfindung hierin mit Bezug auf unterschiedliche Ausführungsformen des Verfahrens zum Herstellen eines Sensormoduls beschrieben sind.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine schematische Querschnittsansicht eines Leiterplattenelements einer Ausführungsform des erfindungsgemäßen Steuermoduls;
- Fig. 2 zeigt: eine Aufsicht auf das Leiterplattenelement aus Fig. 1;
- Fig. 3 zeigt: eine Querschnittsansicht einer Ausführungsform des erfindungsgemäßen Steuermoduls ohne Abdichtungsmaterial und ohne Vergussmaterial;
- Fig. 4 zeigt: eine Aufsicht auf das Steuermodul aus Fig. 3; und
- Fig. 5 zeigt: eine Querschnittsansicht des Steuermoduls aus Fig. 3 bzw. Fig. 4 mit Abdichtungsmaterial und mit Vergussmaterial.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

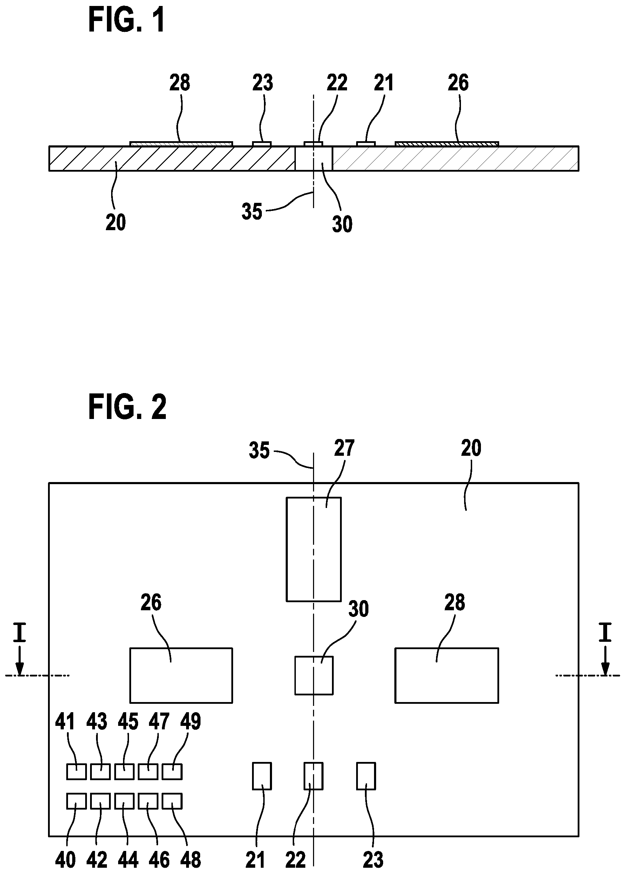

Fig. 1 zeigt eine schematische Querschnittsansicht eines Leiterplattenelements 20 einer Ausführungsform eines Steuermoduls. Fig. 2 zeigt eine Aufsicht auf das Leiterplattenelement 20 aus Fig. 1.

Das Leiterplattenelement 20 kann z.B. ein Printed-Circuit-Board (PCB) sein. Die elektrischen Verbindungen innerhalb des Leiterplattenelements 20 sind in den Zeichnungen nicht dargestellt. Das Leiterplattenelement 20 weist eine mittig angeordnete Aussparung 30 auf, die sich über die komplette Höhe des Leiterplattenelements 20 erstreckt. Die Höhe verläuft in Fig. 1 von oben nach unten und in Fig. 2 in die Zeichenebene hinein bzw. heraus. Eine Mittellinie 35 verläuft mittig durch die Aussparung 30.

Auf dem Leiterplattenelement 20 sind drei mechanische Löt-Pads 26, 27, 28 angeordnet. Diese sind jeweils um einen Winkel von ca. 90° um die Mittellinie 35 herum versetzt angeordnet.

Die mechanischen Löt-Pads 26, 27, 28 dienen zur Herstellung einer mechanischen Verbindung zwischen einem Sensorträger 50, der ein Sensorelement 70 beabstandet zu dem Leiterplattenelement 20 hält, und dem Leiterplattenelement 20. Die mechanischen Löt-Pads 26, 27, 28 sind jeweils rechteckig ausgebildet. Andere Formen sind jeweils vorstellbar.

Zudem sind auf dem Leiterplattenelement 20 drei elektrische Löt-Pads 21, 22, 23 angeordnet. Die elektrischen Löt-Pads 21, 22, 23 dienen zum Herstellen einer elektrischen Verbindung zwischen dem Sensorträger 50 und dem Leiterplattenelement 20 bzw. den elektrischen Leitungen innerhalb des Leiterplattenelements 20. Die elektrischen Löt-Pads 21, 22, 23 sind jeweils rechteckig ausgebildet. Andere Formen sind vorstellbar.

Vorstellbar ist auch, dass die elektrischen Löt-Pads 21, 22, 23 des Leiterplattenelements 20 zugleich die mechanischen Löt-Pads 26, 27, 28 des Leiterplattenelements 20 sind. D.h., dass Löt-Pads des Leiterplattenelements 20 jeweils beide Funktionen zugleich erfüllen.

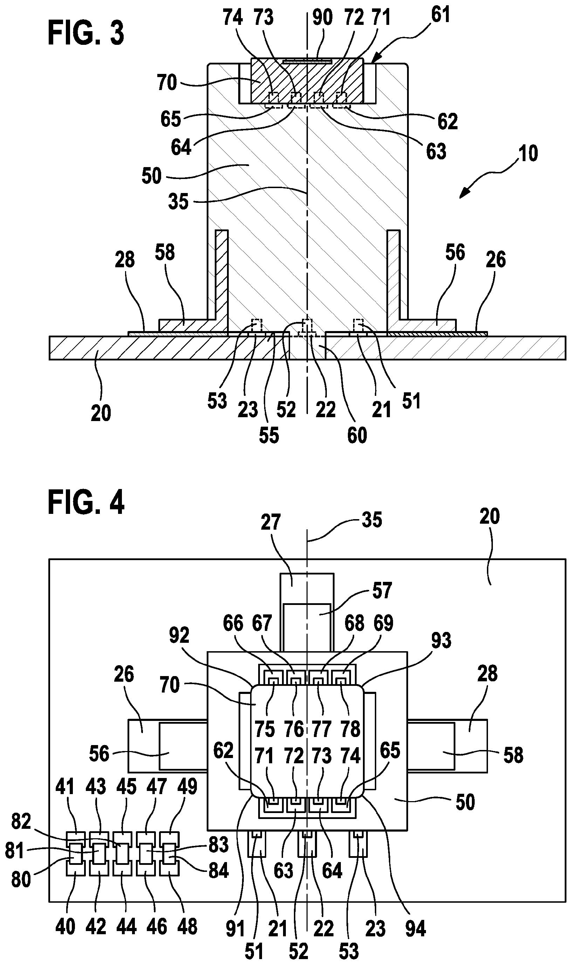

Zudem sind auf dem Leiterplattenelement 20 weitere elektrische Löt-Pads 40-49 angeordnet. Die weiteren elektrischen Löt-Pads 40-49 dienen zur Herstellung jeweils einer elektrischen Verbindung zwischen weiteren elektronischen Bauelementen 80-84, insbesondere passiven elektronischen Bauelementen zum Herstellen einer elektromagnetischen Verträglichkeit (EMV), und dem Leiterplattenelement 20 bzw. den elektrischen Leitungen innerhalb des Leiterplattenelements 20. Die weiteren elektrischen Löt-Pads 40-49 sind jeweils paarig zueinander angeordnet, so dass jeweils zwei der elektrischen Löt-Pads mit einem weiteren elektronischen Bauelement 80-84 verbunden werden. Die weiteren elektrischen Löt-Pads 40-49 können auch zum mechanischen Befestigen der weiteren elektronischen Bauelemente 80-84 auf dem Leiterplattenelement 20 dienen. Die Anzahl der weiteren elektronischen Bauelemente 80-84 beträgt in Fig. 4 fünf. Auch lediglich eins, zwei, drei, vier weitere elektronische Bauelemente 80-84 sind vorstellbar.

Alle genannten Löt-Pads 21, 22, 23 des Leiterplattenelements 20 befinden sich auf derselben Seite des Leiterplattenelements 20.

Die Anzahl an elektrischen Löt-Pads 21, 22, 23 und/oder der mechanischen Löt-Pads 26, 27, 28 des Leiterplattenelements 20 als auch des Sensorträgers 50 kann jeweils größer oder kleiner als drei sein, z.B. zwei, vier, fünf oder mehr als fünf. In der Regel ist die Anzahl der elektrischen Löt-Pads 51, 52, 53 des Sensorträgers 50 genauso groß wie die Anzahl der elektrischen Löt-Pads 21, 22, 23 des Leiterplattenelements 20. Die Anzahl der mechanischen Löt-Pads 56, 57, 58 des Sensorträgers 50 ist typischerweise genauso groß wie die Anzahl der mechanischen Löt-Pads 21, 22, 23 des Leiterplattenelements 20.

Nun wird ein erstes Löt-Material (z.B. Weichlot in Form einer Lötpaste) auf die elektrischen Löt-Pads 21, 22, 23 und die mechanischen Löt-Pads 26, 27, 28 des Leiterplattenelements 20 aufgebracht. Alternativ oder zusätzlich kann das erste Löt-Material auf die elektrischen Löt-Pads 21, 22, 23 und die mechanischen Löt-Pads der Leiterplattenelementkontaktseite 55 des Sensorträgers 50 aufgebracht werden. Auch eine Mischung hiervon ist möglich, d.h., dass erstes Lötmaterial auf einen Teil der elektrischen Löt-Pads 21, 22, 23 und/oder einen Teil der mechanischen Löt-Pads 26, 27, 28 des Leiterplattenelements 20 aufgebracht wird und auf einen Teil der elektrischen Löt-Pads 51, 52, 53 und/oder einen Teil der mechanischen Löt-Pads 56, 57, 58 des Sensorträgers 50. Relevant ist, dass nach dem Anordnen des Sensorträgers 50 auf dem Leiterplattenelement 20 zwischen jedem Löt-Pad 51, 52, 53 des Sensorträgers 50 und jedem Löt-Pad 21, 22, 23, 26, 27, 28 des Leiterplattenelements 20 erstes Lötmaterial angeordnet ist. Das Aufbringen kann z.B. durch Dispensen durchgeführt werden. Fig. 3 zeigt eine Querschnittsansicht einer Ausführungsform des

Steuermoduls ohne Abdichtungsmaterial 96 und ohne Vergussmaterial 95. Fig. 4 zeigt eine Aufsicht auf das Steuermodul aus Fig. 3 Ein Sensorträger 50 bzw. Sensordom wird nun auf dem Leiterplattenelement 20 angeordnet und mit seinem Vorsprung 60 in die Aussparung 30 des Leiterplattenelements 20 eingeführt. Der Sensorträger 50 weist eine dem Leiterplattenelement 20 zugewandte Leiterplattenelementkontaktseite 55 auf. Diese befindet sich in Fig. 3 auf der unteren Seite des Sensorträgers 50. Auf dem der Leiterplattenelementkontaktseite 55 abgewandten Seit ist eine Sensoraufnahme 61 zum Aufnehmen eines Sensorelements 70 ausgebildet. Die Sensoraufnahme 61 kann z.B. eine Vertiefung bzw. Aussparung 30 mit einem umlaufenden Rand sein.

Der Sensorträger 50 weist auf der Leiterplattenelementkontaktseite 55 drei mechanische Löt-Pads 56, 57, 58 auf. Die drei mechanischen Löt-Pads 56, 57, 58 sind jeweils Teil eines L-förmig ausgebildeten mechanischen Befestigungselements.

Der Sensorträger 50 weist auf der Leiterplattenelementkontaktseite 55 drei elektrische Löt-Pads 51, 52, 53 auf. Die elektrischen Löt-Pads 51, 52, 53 des Sensorträgers 50 sind über Verbindungsleitungen innerhalb des Sensorträgers 50 (nicht gezeigt) mit elektrischen Löt-Pads 62-69 der Sensoraufnahme 61 elektrisch verbunden.

Die elektrischen Löt-Pads 51, 52, 53 und mechanischen Löt-Pads 56, 57, 58 des Sensorträgers 50 sind derart ausgebildet und der Sensorträger 50 wird derart mit seiner Leiterplattenelementkontaktseite 55 auf dem Leiterplattenelement 20 angeordnet, dass sich die elektrischen Löt-Pads 51, 52, 53 und mechanischen Löt-Pads 56, 57, 58 des Sensorträgers 50 jeweils auf elektrischen Löt-Pads 21, 22, 23 bzw. mechanischen Löt-Pads 26, 27, 28 des Leiterplattenelements 20 befinden. Typischerweise sind die Löt-Pads 21, 22, 23, 26, 27, 28 des Leiterplattenelements 20 jeweils großflächiger als die Löt-Pads 51, 52, 53 des Sensorträgers 50.

Die elektrischen Löt-Pads 21, 22, 23 und/oder mechanischen Löt-Pads 26, 27, 38 des Leiterplattenelements 20 verlaufen jeweils parallel zu den elektrischen Löt-Pads 51, 52, 53 und/oder mechanischen Löt-Pads 56, 57, 58 des Sensorträgers 50.

Das Sensorelement 70 wird -entweder bevor der Sensorträger 50 auf dem Leiterplattenelement 20 angeordnet wird oder nachdem der Sensorträger 50 auf dem Leiterplattenelement 20 angeordnet wird- in der Sensoraufnahme 61 angeordnet.

Vor dem Anordnen des Sensorelements 70 in der Sensoraufnahme 61 wird ein zweites Lötmaterial auf die elektrischen Löt-Pads 62-69 der Sensoraufnahme 61 und/oder auf elektrische Verbindungselemente 71-78 des Sensorelements 70aufgebracht.

Zudem kann ein sogenannter back-bias-magnet in Form eines Permanentmagneten in eine Vertiefung innerhalb der Sensoraufnahme 61 eingebracht werden. Nachdem das Sensorelement 70 in die Sensoraufnahme 61 eingebracht wurde, befindet sich der back-bias-magnet zwischen dem Sensorelement 70 bzw. dem Sensor 90 und dem Leiterplattenelement 20. Der Sensor 90 kann in diesem Fall insbesondere ein Hall-Sensor zum Messen eines Magnetfelds sein.

Das Sensorelement 70 weist zumindest einen Sensor 90 auf. Vorstellbar sind auch zwei, drei oder mehr als drei Sensoren. Der Sensor 90 ist in dem Sensorelement 70 eingekapselt. Das Sensorelement 70 weist elektrische Verbindungselemente 71-78 auf. Die elektrischen Verbindungselemente 71-78 können z.B. Pins des Sensors 90 sein. Auch vorstellbar ist, dass das Sensorelement 70 Löt-Pads als elektrische Verbindungselemente 71-78 aufweist.

Das Sensorelement 70 ist derart ausgebildet und wird derart angeordnet, dass jeweils eine elektrische Verbindung zwischen den elektrischen Verbindungselementen 71-78 und den Löt-Pads 62-69 der Sensoraufnahme 61 gebildet wird. Die Löt-Pads 62-69 der Sensoraufnahme 61 sind über Verbindungsleitungen mit den Löt-Pads 51, 52, 53 auf der Leiterplattenelementkontaktseite 55 des Sensorträgers 50 elektrisch verbunden. Folglich wird der Sensor 90 über die elektrischen Verbindungsleitung des Sensorträgers 50 mit dem Leiterplattenelement 20 elektrisch verbunden.

Die Anzahl an elektrischen Verbindungselementen 71-78 beträgt in Fig. 4 acht. Vorstellbar ist auch, dass das Sensorelement 70 vier, fünf, sechs, sieben, neun, zehn oder mehr als zehn elektrische Verbindungselemente 71-78 aufweist. Die Anzahl an Löt-Pads 62-69 der Sensoraufnahme 61 ist zumindest so groß wie die Anzahl an elektrischen Verbindungselementen 71-78 des Sensorelements 70. Typischerweise entspricht die Anzahl an Löt-Pads 62-69 der Sensoraufnahme 61 der Anzahl der Pins des Sensorelements 70.

Das Sensorelement 70 bzw. der Sensor 90 umfasst in den Zeichnungen jeweils ein dual flat no-lead package.

Die Sensoraufnahme umfasst vier um die Mittellinie in einem Winkelversatz von 90° angeordnete Ausrichtungselemente 91-94, die jeweils eine Ecke des quaderförmigen Sensorelements 70 in einer Vertiefung des Ausrichtungselements 91-94 aufnehmen. Hierdurch gelangen die elektrischen Verbindungselemente 71-78 des Sensorelements 70 auf die Löt-Pads 62-69 der Sensoraufnahme 61.

Zudem werden weitere elektronische Bauelemente 80-84 derart auf dem Leiterplattenelement 20 angeordnet, dass jedes weitere elektronische Bauelement mit genau zwei der weiteren Löt-Pads 40-49 des Leiterplattenelements 20 verbunden ist.

Nun wird das Sensormodul 10 reflow-gelötet. Dies kann z.B. durch Erwärmen bzw. Erhitzen des Sensormoduls 10 in einem Reflow-Lötofen durchgeführt werden. In einem gemeinsamen bzw. in einem einzigen Reflow-Lötvorgang bzw. Reflow-Lötdurchgang werden die Verbindungen zwischen den elektrischen Löt-Pads 21, 22, 23 des Leiterplattenelements 20 und den elektrischen Löt-Pads 51, 52, 53 des Sensorträgers 50, zwischen den mechanischen Löt-Pads 26, 27, 28 des Leiterplattenelements 20 und den mechanischen Löt-Pads 56, 57, 58 des Sensorträgers 50 und zwischen den Löt-Pads 62-69 der Sensoraufnahme 61 und den elektrischen Verbindungselementen 71-78 des Sensorelements 70 reflow-gelötet. Somit wird durch diesen einen gemeinsamen Reflow-Lötvorgang die elektrische und mechanische Verbindung zwischen dem Sensorelement 70, dem Sensorträger 50 und dem Leiterplattenelement 20 hergestellt.

Nach diesem Reflow-Lötvorgang ist das Sensorelement 70 mechanisch und elektrisch mit dem Sensorträger 50 verbunden und der Sensorträger 50 ist mechanisch und elektrisch mit dem Leiterplattenelement 20 verbunden.

Der Sensorträger 50 besteht aus einem Material, das bei dem Reflow-Lötvorgang seine Form im Wesentlichen nicht ändert. Das Material des Sensorträgers 50 kann Kunststoff sein oder Kunststoff umfassen.

Dadurch dass nur ein einziger Reflow-Lötvorgang zum mechanischen Befestigen und elektrischen Verbinden benötigt wird, wird Zeit und Energie gespart.

Nach dem Reflow-Lötvorgang wird ein Abdichtungsmaterial 96 auf die elektrischen Löt-Pads 21, 22, 23 des Leiterplattenelements 20 bzw. des Sensorträgers 50 aufgebracht.

Es wird ein Vergussmaterial 95 auf das Leiterplattenelement 20 aufgebracht, das alle Löt-Pads 21, 22, 23 des Leiterplattenelements 20 und alle Löt-Pads 56, 57, 58 auf der Leiterplattenelementkontaktseite 55 des Sensorträgers 50 sowie die weiteren elektronischen Bauelemente 80-84 bedeckt. Auch wird Vergussmaterial 95 in die Sensoraufnahme 61 eingebracht, so dass eine von dem Sensorträger 50 abgewandte Seite bzw. Fläche des Sensorträgers 50 nicht von dem Vergussmaterial 95 bedeckt wird. Der Sensor 90 ist innerhalb des Sensorelements 70 in der Nähe dieser Seite bzw. Fläche angeordnet. Hierdurch kann ein Luftspalt zwischen dem Sensor 90 und dem zu messenden Objekt (z.B. einem Rad) gering gehalten werden.

Anschließend werden das Vergussmaterial 95 in der Sensoraufnahme 61 und das Vergussmaterial 95 auf dem Leiterplattenelement 20 ausgehärtet. Dies kann z.B. durch Erwärmen bzw. Erhitzen durchgeführt werden.

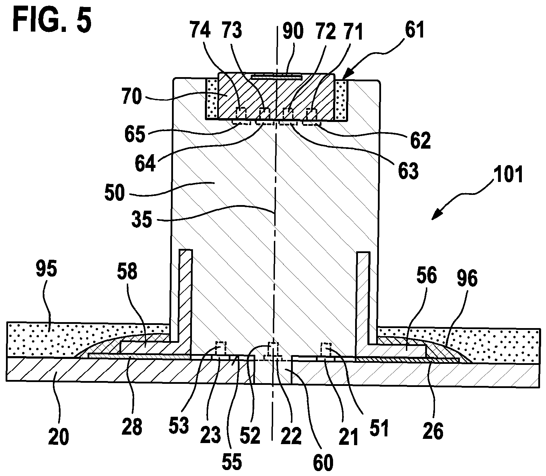

Fig. 5 zeigt eine Querschnittsansicht des Steuermoduls aus Fig. 3 bzw. Fig. 4 mit Abdichtungsmaterial 96 und mit Vergussmaterial 95. Fig. 5 zeigt das fertige elektronische Sensormodul 10. Das elektronische Sensormodul 10 kann in einem Getriebe, z.B. in einem Getriebe eines Fahrzeugs, eingesetzt werden.

Das Sensorelement 70 bzw. der Sensor 90 kann ein dual flat no-lead (DFN)-package umfassen oder sein. Insbesondere kann das Sensorelement 70 bzw. der Sensor 90 ein IC mit Anschlusspads bzw. elektrischen Verbindungselementen 71-78 auf sich gegenüberliegenden Seiten umfassen oder sein. Auch ist denkbar, dass das Sensorelement 70 bzw. der Sensor 90 ein land grid array (LGA)-package umfasst oder ist. Ebenfalls ist ein quad flat no-lead package als Sensorelement 70 bzw. Sensor 90 oder als Teil hiervon denkbar. Wenn es auf Bauraum nicht ankommt, kann auch jedes andere Standard SMD-Gehäuse, wie z.B. SOIC8 oder SOT89, SOT23 verwendet werden.

Die elektrischen Verbindungsleitungen innerhalb des Sensorträgers 50 können eingegossene oder umspritzte metallene Elemente sein. Alternativ können die elektrischen Verbindungsleitungen des Sensorträgers 50 in den Sensorträger 50 bzw. das Material des Sensorträgers 50 eingeschossene Elemente aufweisen. Dies bedeutet, dass die elektrischen Verbindungsleitungen erst nach dem Ausbilden des Materials bzw. der Form des Sensorträgers 50 in den Sensorträger 50 eingebracht werden. Die eingeschossenen Elemente weisen an ihren beiden gegenüberliegenden Enden jeweils umbiegbare Teile zum Bilden der elektrischen Löt-Pads 51, 52, 53 auf.

Das jeweilige Löt-Pad 21, 22, 23, 26, 27, 28 kann insbesondere eine Fläche oder eine Stelle umfassen, die über ein Löt-Material mit einem anderen Löt-Pad 21, 22, 23, 26, 27, 28 oder einem elektrischen Verbindungselement (z.B. einem Pin eines integrated circuit) mechanisch und/oder elektrisch verbindbar ist.

Vor dem Anordnen des Sensorträgers 50 auf dem Leiterplattenelement 20 kann ein Reflow-Klebstoff auf die Löt-Pads 51, 52, 53 des Sensorträgers 50 und/oder des Leiterplattenelements 20 aufgebracht werden. Hierdurch wird eine besonders sichere Fixierung des Statorträgers auf dem Leiterplattenelement 20 vor dem Reflow-Löten erreicht werden. Gleiches gilt für die Löt-Pads 62-69 der Sensoraufnahme 61.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Verfahren zum Herstellen eines elektronischen Sensormoduls (10) zum Messen mindestens einen Messwerts, insbesondere für eine Getriebesteuerung, wobei das Verfahren folgende Schritte umfasst:
Bereitstellen eines Leiterplattenelements (20);
Bereitstellen eines Sensorelements (70);
Bereitstellen eines Sensorträgers (50) mit einer Sensoraufnahme (61) zum Aufnehmen des Sensorelements (70), wobei die Sensoraufnahme (61) Ausrichtungselemente (91-94) zum Ausrichten des Sensorelements (70) in der Sensoraufnahme (61) aufweist, wobei der Sensorträger (50) elektrische Verbindungsleitungen zwischen Löt-Pads (62-69) der Sensoraufnahme (61) und elektrischen Löt-Pads (21, 22, 23) einer Leiterplattenelementkontaktseite (55) des Sensorträgers (50) aufweist, wobei die Sensoraufnahme (61) auf einer der Leiterplattenelementkontaktseite (55) abgewandten Seite des Sensorträgers (50) ausgebildet ist;
Aufbringen von erstem Lötmaterial auf elektrische Löt-Pads (21, 22, 23) des Leiterplattenelements (20) und/oder auf die elektrischen Löt-Pads (51, 52, 53) der Leiterplattenelementkontaktseite (55) des Sensorträgers (50);
Anordnen des Sensorträgers (50) mit den elektrischen Löt-Pads (51, 52, 53) der Leiterplattenelementkontaktseite (55) auf den elektrischen Löt-Pads (21, 22, 23) des Leiterplattenelements (20) zum Herstellen jeweils einer elektrischen Verbindung zwischen der Verbindungsleitung und dem Leiterplattenelement (20) über das erste Lötmaterial;
Aufbringen von zweitem Lötmaterial auf elektrische Verbindungselemente (71-78) des Sensorelements (70) und/oder auf die Löt-Pads (62-69) der Sensoraufnahme (61);
Anordnen des Sensorelements (70) in der Sensoraufnahme (61) derart, dass das zweite Lötmaterial jeweils eine elektrische Verbindung zwischen den elektrischen Verbindungselementen (71-78) des Sensorelements (70) und den Löt-Pads (62-69) der Sensoraufnahme (61) über das zweite Lötmaterial herstellt; und
Reflow-Löten des ersten Lötmaterials und des zweiten Lötmaterials in einem gemeinsamen Reflow-Lötvorgang.

2. Verfahren nach Anspruch 1, wobei
das Verfahren ferner folgende Schritte umfasst:
Bereitstellen von weiteren elektronischen Bauelementen (80-84), insbesondere von weiteren elektronischen Bauelementen (80-84), vorzugsweise weiteren passiven elektronischen Bauelementen, zum Herstellen einer elektromagnetischen Verträglichkeit des Sensormoduls (10);
Aufbringen eines dritten Lötmaterials auf elektrische Verbindungselemente (71-78) der weiteren elektronischen Bauelemente (80-84) und/oder auf weitere Löt-Pads (40-49) des Leiterplattenelements (20); und
Anordnen der weiteren elektronischen Bauelemente (80-84) jeweils auf den weiteren Löt-Pads (40-49) des Leiterplattenelements (20) zum Herstellen jeweils einer elektrischen Verbindung zwischen den weiteren elektronischen Bauelementen (80-84) und dem Leiterplattenelement (20) über das dritte Lötmaterial;
wobei das dritte Lötmaterial in demselben Reflow-Lötvorgang reflow-gelötet wird, in dem das erste Lötmaterial und das zweite Lötmaterial gemeinsam reflow-gelötet wird.

3. Verfahren nach Anspruch 1 oder 2, wobei
das Leiterplattenelement (20) ferner mechanische Löt-Pads (26, 27, 28) und die Leiterplattenelementkontaktseite (55) des Sensorträgers (50) ferner mechanische Löt-Pads (56, 57, 58) umfasst, wobei auf die mechanischen Löt-Pads (26, 27, 28) des Leiterplattenelements (20) und/oder der Leiterplattenelementkontaktseite (55) des Sensorträgers (50) ebenfalls erstes Lötmaterial aufgetragen wird,
wobei bei dem Anordnen des Sensorträgers (50) mit der Leiterplattenelementkontaktseite (55) auf dem Leiterplattenelement (20) zudem die mechanischen Löt-Pads (56, 57, 58) der Leiterplattenelementkontaktseite (55) des Sensorträgers (50) über das erste Lötmaterial mit den mechanischen Löt-Pads (26, 27, 28) des Leiterplattenelements (20) verbunden werden,
wobei das erste Lötmaterial der mechanischen Löt-Pads (26, 27, 28) in demselben Reflow-Lötvorgang wie das erste Lötmaterial der elektrischen Löt-Pads (21, 22, 23) reflow-gelötet wird.

4. Verfahren nach einem der vorhergehenden Ansprüche, wobei der Sensorträger (50) ausschließlich über das erste Lötmaterial mechanisch mit dem Leiterplattenelement (20) verbunden ist.

5. Verfahren nach einem der vorhergehenden Ansprüche, wobei das Sensorelement (70) ausschließlich über das zweite Lötmaterial mechanisch mit dem Sensorträger (50) verbunden ist.

6. Verfahren nach einem der vorhergehenden Ansprüche, wobei das Verfahren ferner folgenden Schritt umfasst:
Aufbringen eines Vergussmaterials (95) auf zumindest einen Teil des Leiterplattenelements (20) derart, dass die elektrische Verbindung oder die elektrischen Verbindungen zwischen dem Sensorträger (50) und dem Leiterplattenelement (20) von dem Vergussmaterial (95) bedeckt sind, und in zumindest einen Teil der Sensoraufnahme (61) derart, dass die elektrischen Verbindungen zwischen dem Sensorelement (70) und dem Sensorträger (50) bedeckt sind.

7. Verfahren nach einem der vorhergehenden Ansprüche, wobei das Vergussmaterial (95) derart in die Sensoraufnahme (61) eingebracht wird, dass ein von dem Sensorträger (50) abgewandte Seite des Sensorelements (70) nicht von dem Vergussmaterial (95) bedeckt ist.

8. Verfahren nach einem der vorhergehenden Ansprüche, wobei das Sensorelement (70) einen Hall-Sensor umfasst,
wobei die Sensoraufnahme (61) eine Vertiefung zum Aufnehmen eines Dauermagneten derart aufweist, dass der Dauermagnet zwischen dem Sensorelement (70) und dem Leiterplattenelement (20) anordenbar ist, wobei vor dem Einbringen des Sensorelements (70) in die Sensoraufnahme (61), der Dauermagnet in die Vertiefung eingebracht wird.

## Claims

1. Method for producing an electronic sensor module (10) for measuring at least one measured value, in particular for a transmission controller, wherein the method comprises the following steps:
providing a printed circuit board element (20);
providing a sensor element (70);
providing a sensor carrier (50) having a sensor receptacle (61) for holding the sensor element (70),
wherein the sensor receptacle (61) has alignment elements (91-94) for aligning the sensor element (70) in the sensor receptacle (61), wherein the sensor carrier (50) has electric connecting lines between solder pads (62-69) of the sensor receptacle (61) and electric solder pads (21, 22, 23) of a printed circuit board element contact side (55) of the sensor carrier (50), wherein the sensor receptacle (61) is formed on a side of the sensor carrier (50) that faces away from the printed circuit board element contact side (55);
applying first solder material to electric solder pads (21, 22, 23) of the printed circuit board element (20) and/or to the electric solder pads (51, 52, 53) of the printed circuit board element contact side (55) of the sensor carrier (50);
arranging the sensor carrier (50) with the electric solder pads (51, 52, 53) of the printed circuit board element contact side (55) on the electric solder pads (21, 22, 23) of the printed circuit board element (20) to produce a respective electric connection between the connecting line and the printed circuit board element (20) via the first solder material;
applying second solder material to electric connecting elements (71-78) of the sensor element (70) and/or to the solder pads (62-69) of the sensor receptacle (61);
arranging the sensor element (70) in the sensor receptacle (61) in such a way that the second solder material produces a respective electric connection between the electric connecting elements (71-78) of the sensor element (70) and the solder pads (62-69) of the sensor receptacle (61) via the second solder material;
and
reflow-soldering the first solder material and the second solder material in a common reflow soldering process.

2. Method according to Claim 1, wherein
the method further comprises the following steps:
providing further electronic components (80-84), in particular further electronic components (80-84), preferably further passive electronic components, to produce electromagnetic compatibility of the sensor module (10);
applying a third solder material to electric connecting elements (71-78) of the further electronic components (80-84) and/or to further solder pads (40-49) of the printed circuit board element (20); and
arranging the further electronic components (80-84) each on the further solder pads (40-49) of the printed circuit board element (20) to produce a respective electric connection between the further electronic components (80-84) and the printed circuit board element (20) via the third solder material;
wherein the third solder material is reflow-soldered in the same reflow soldering process in which the first solder material and the second solder material are jointly reflow-soldered.

3. Method according to Claim 1 or 2, wherein
the printed circuit board element (20) further comprises mechanical solder pads (26, 27, 28) and the printed circuit board element contact side (55) of the sensor carrier (50) further comprises mechanical solder pads (56, 57, 58), wherein first solder material is likewise applied to the mechanical solder pads (26, 27, 28) of the printed circuit board element (20) and/or of the printed circuit board element contact side (55) of the sensor carrier (50),
wherein, as the sensor carrier (50) is arranged with the printed circuit board element contact side (55) on the printed circuit board element (20), the mechanical solder pads (56, 57, 58) of the printed circuit board element contact side (55) of the sensor carrier (50) are connected to the mechanical solder pads (26, 27, 28) of the printed circuit board element (20) via the first solder material,
wherein the first solder material of the mechanical solder pads (26, 27, 28) is reflow-soldered in the same reflow soldering process as the first solder material of the electric solder pads (21, 22, 23).

4. Method according to one of the preceding claims, wherein
the sensor carrier (50) is connected mechanically to the printed circuit board element (20) exclusively via the first solder material.

5. Method according to one of the preceding claims, wherein
the sensor element (70) is connected mechanically to the sensor carrier (50) exclusively via the second solder material.

6. Method according to one of the preceding claims, wherein
the method further comprises the following step:
applying an encapsulation material (95) to at least part of the printed circuit board element (20) in such a way that the electric connection or the electric connections between the sensor carrier (50) and the printed circuit board element (20) are covered by the encapsulation material (95), and in at least part of the sensor receptacle (61) in such a way that the electric connections between the sensor element (70) and the sensor carrier (50) are covered.

7. Method according to one of the preceding claims, wherein
the encapsulation material (95) is introduced into the sensor receptacle (61) in such a way that a side of the sensor element (70) that faces away from the sensor carrier (50) is not covered by the encapsulation material (95) .

8. Method according to one of the preceding claims, wherein
the sensor element (70) comprises a Hall sensor, wherein the sensor receptacle (61) has a recess for receiving a permanent magnet in such a way that the permanent magnet can be arranged between the sensor element (70) and the printed circuit board element (20), wherein the permanent magnet is introduced into the recess before the sensor element (70) is introduced into the sensor receptacle (61).

## Revendications

1. Procédé de fabrication d'un module de détection électronique (10) destiné à mesurer au moins une valeur de mesure, notamment destinée à une commande de transmission, le procédé comprenant les étapes suivantes :
fournir un élément formant carte de circuit imprimé (20) ;
fournir un élément formant capteur (70) ;
fournir un support de capteur (50) comprenant un logement de capteur (61) destiné à recevoir l'élément formant capteur (70), le logement de capteur (61) comportant des éléments d'orientation (91-94) destinés à orienter l'élément formant capteur (70) dans le logement de capteur (61), le support de capteur (50) comportant des lignes de liaison électrique entre des pastilles de brasage (62-69) du logement de capteur (61) et des pastilles de brasage électrique (21, 22, 23) sur un côté contact d'élément formant carte de circuit imprimé (55) du support de capteur (50), le logement de capteur (61) étant formé sur un côté support de capteur (50) qui est à l'opposé du côté contact d'élément formant carte de circuit imprimé (55) ;
appliquer une première matière de brasage sur des pastilles de brasage électrique (21, 22, 23) de l'élément formant carte de circuit imprimé (20) et/ou sur les pastilles de brasage électrique (51, 52, 53) du côté contact d'élément formant carte de circuit imprimé (55) du support de capteur (50) ;
disposer le support de capteur (50) avec les pastilles de brasage électrique (51, 52, 53) du côté contact de l'élément formant carte de circuit imprimé (55) sur les pastilles de brasage électrique (21, 22, 23) de l'élément formant carte de circuit imprimé (20) afin de réaliser une liaison électrique entre la ligne de liaison et l'élément formant carte de circuit imprimé (20) par le biais de la première matière de brasage ;
appliquer une deuxième matière de brasage sur des éléments de liaison électrique (71-78) de l'élément formant capteur (70) et/ou sur les pastilles de brasage (62-69) du logement de capteur (61) ;
disposer l'élément formant capteur (70) dans le support de capteur (61) de sorte que la deuxième matière de brasage réalise une liaison électrique entre les éléments de liaison électrique (71-78) de l'élément formant capteur (70) et les pastilles de brasage (62 - 69) du support de capteur (61) par le biais de la deuxième matière de brasage ; et
effectuer un brasage par fusion de la première matière de brasage et de la deuxième matière de brasage dans un processus de brasage par fusion commun.

2. Procédé selon la revendication 1,
le procédé comprenant en outre les étapes suivantes :
fournir d'autres composants électroniques (80-84), en particulier d'autres composants électroniques (80-84), de préférence d'autres composants électroniques passifs, pour réaliser la compatibilité électromagnétique du module formant capteur (10) ;
appliquer une troisième matière de brasage sur des éléments de liaison électrique (71-78) des autres composants électroniques (80-84) et/ou sur d'autres pastilles de brasage (40-49) de l'élément formant carte de circuit imprimé (20) ; et
disposer les autres composants électroniques (80-84) sur les autres pastilles de brasage (40-49) de l'élément formant carte de circuit imprimé (20) afin de réaliser une liaison électrique entre les autres composants électroniques (80-84) et l'élément formant carte de circuit imprimé (20) par le biais de la troisième matière de brasage ;
la troisième matière de brasage étant brasée par fusion dans le même processus de brasage par fusion dans lequel la première matière de brasage et la deuxième matière de brasage sont brasées conjointement par fusion.

3. Procédé selon la revendication 1 ou 2,
l'élément formant carte de circuit imprimé (20) comprenant en outre des pastilles de brasage mécanique (26, 27, 28) et le côté contact d'élément formant carte de circuit imprimé (55) du support de capteur (50) comprenant en outre des pastilles de brasage mécanique (56, 57, 58), une première matière de brasage étant également appliquée sur les pastilles de brasage mécanique (26, 27, 28) de l'élément formant carte de circuit imprimé (20) et/ou sur le côté contact de l'élément formant carte de circuit imprimé (55) du support de capteur (50),
lorsque le support de capteur (50) est disposé avec le côté contact d'élément formant carte de circuit imprimé (55) sur l'élément formant carte de circuit imprimé (20), les pastilles de brasage mécanique (56, 57, 58) du côté contact d'élément formant carte de circuit imprimé (55) du support de capteur (50) étant également reliées par le biais de la première matière de brasage aux pastilles de brasage mécanique (26, 27, 28) de l'élément formant carte de circuit imprimé (20),
la première matière de brasage des pastilles de brasage mécanique (26, 27, 28) étant brasée par fusion dans le même processus de brasage par fusion que la première matière de brasage des pastilles de brasage électrique (21, 22, 23).

4. Procédé selon l'une des revendications précédentes, le support de capteur (50) étant relié mécaniquement à l'élément formant carte de circuit imprimé (20) exclusivement par le biais de la première matière de brasage.

5. Procédé selon l'une des revendications précédentes, l'élément formant capteur (70) étant relié mécaniquement au support de capteur (50) exclusivement par le biais de la deuxième matière de brasage.

6. Procédé selon l'une des revendications précédentes, le procédé comprenant en outre l'étape suivante :
appliquer une matière d'enrobage (95) sur au moins une partie de l'élément formant carte de circuit imprimé (20) de sorte que la liaison électrique ou les liaisons électriques entre le support de capteur (50) et l'élément formant carte de circuit imprimé (20) soient recouvertes par la matière d'enrobage (95), et dans au moins une partie du support de capteur (61) de sorte que les liaisons électriques entre l'élément formant capteur (70) et le support de capteur (50) soient recouvertes.

7. Procédé selon l'une des revendications précédentes, la matière d'enrobage (95) étant introduite dans le logement de capteur (61) de manière à ce qu'un côté de l'élément de capteur (70) qui est opposé au support de capteur (50) ne soit pas recouvert par la matière d'enrobage (95).

8. Procédé selon l'une des revendications précédentes, l'élément formant capteur (70) comprenant un capteur à effet Hall,
le logement de capteur (61) comportant une dépression destinée à recevoir un aimant permanent de manière à ce que l'aimant permanent puisse être disposé entre l'élément formant capteur (70) et l'élément formant carte de circuit imprimé (20),
l'aimant permanent étant introduit dans la dépression avant d'introduire l'élément formant capteur (70) dans le logement de capteur (61).
